(19) Europäisches Patentamt
European Patent Office
Office européen des brevets

(11) **EP 2 987 165 B1**

(12) **FASCICULE DE BREVET EUROPEEN**

(45) Date de publication et mention de la délivrance du brevet:
**10.10.2018 Bulletin 2018/41**

(21) Numéro de dépôt: **14722289.7**

(22) Date de dépôt: **17.04.2014**

(51) Int Cl.:
**G10L 19/005** (2013.01)   **G10L 21/0208** (2013.01)

(86) Numéro de dépôt international:
**PCT/FR2014/050945**

(87) Numéro de publication internationale:
**WO 2014/170617 (23.10.2014 Gazette 2014/43)**

(54) **CORRECTION DE PERTE DE TRAME PAR INJECTION DE BRUIT PONDÉRÉ**

RAHMENAUSFALLKORREKTUR DURCH INJEKTION VON GEWICHTETEM RAUSCHEN

FRAME LOSS CORRECTION BY WEIGHTED NOISE INJECTION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.04.2013 FR 1353551**

(43) Date de publication de la demande:
**24.02.2016 Bulletin 2016/08**

(73) Titulaire: **Orange**
**75015 Paris (FR)**

(72) Inventeurs:
• **DANIEL, Jérôme**
**22710 Penvenan (FR)**
• **FAURE, Julien**
**22300 Ploubezre (FR)**

(74) Mandataire: **Cabinet Plasseraud**
**66, rue de la Chaussée d'Antin**
**75440 Paris Cedex 09 (FR)**

(56) Documents cités:
**US-A1- 2008 294 428    US-B1- 6 952 668**

• **MAHFUZ E: "Packet loss concealment for voice transmission over IP networks", THESIS SUBMITTED TU THE FACULTY OF GRADUATE STUDIES AND RESEARCHIN PARTIAL FULFILLMENT OF THE REQUIREMENTS FOR THE DEGREE OFENGINEERING AT THE MCGILL UNIVERSITY OF MONTREAL, XX, XX, 27 septembre 2001 (2001-09-27), pages 1-107, XP002309265,**

• **BYEONG HOON KIM ET AL: "VoIP receiver-based adaptive playout scheduling and packet loss concealment technique", IEEE TRANSACTIONS ON CONSUMER ELECTRONICS, IEEE SERVICE CENTER, NEW YORK, NY, US, vol. 59, no. 1, 1 février 2013 (2013-02-01), pages 250-258, XP011499430, ISSN: 0098-3063, DOI: 10.1109/TCE.2013.6490267**

• **LINDBLOM J ET AL: "Packet loss concealment based on sinusoidal extrapolation", 2002 IEEE INTERNATIONAL CONFERENCE ON ACOUSTICS, SPEECH, AND SIGNAL PROCESSING. PROCEEDINGS. (ICASSP). ORLANDO, FL, MAY 13 - 17, 2002; [IEEE INTERNATIONAL CONFERENCE ON ACOUSTICS, SPEECH, AND SIGNAL PROCESSING (ICASSP)], NEW YORK, NY : IEEE, US, vol. 1, 13 mai 2002 (2002-05-13), pages I-173, XP010804675, ISBN: 978-0-7803-7402-7**

• **SERIZAWA M ET AL: "A packet loss concealment method using pitch waveform repetition and internal state update on the decoded speech for the sub-band adpcm wideband speech codec", SPEECH CODING, 2002, IEEE WORKSHOP PROCEEDINGS. OCT. 6-9, 2002, PISCATAWAY, NJ, USA,IEEE, 6 octobre 2002 (2002-10-06), pages 68-70, XP010647215, ISBN: 978-0-7803-7549-9**

• **Alexey Lukin ET AL: "Audio Engineering Society Convention Paper Parametric Interpolation of Gaps in Audio Signals", 125th convention of the audio engineering society, 2 October 2008 (2008-10-02), XP055390370, Retrieved from the Internet: URL:http://audio.rightmark.org/lukin/pub/L ukinTodd10.pdf [retrieved on 2017-07-12]**

EP 2 987 165 B1

• EMRE GÜNDÜZHANGUNDUZHAN ET AL: "A Linear Prediction Based Packet Loss Concealment Algorithm for PCM Coded Speech", IEEE TRANSACTIONS ON SPEECH AND AUDIO PROCESSING, IEEE SERVICE CENTER, NEW YORK, NY, US, vol. 9, no. 8, 1 November 2001 (2001-11-01), XP011054140, ISSN: 1063-6676

**Description**

La présente invention concerne une correction de signal, notamment auprès d'un décodeur en cas de perte de trame à la réception du signal par ce décodeur.

Le signal se présente sous la forme d'une succession d'échantillons, découpée en trames successives et on entend alors par « trame » un segment de signal composé d'au moins un échantillon (la réalisation d'une trame comportant un échantillon unique correspondant alors simplement à un signal sous la forme d'une succession d'échantillons).

L'invention se situe dans le domaine du traitement numérique du signal, notamment mais non exclusivement dans le domaine du codage/décodage d'un signal audio. Les pertes de trames interviennent lorsqu'une communication (soit par transmission en temps-réel, soit par stockage en vue d'une transmission ultérieure) utilisant un codeur et un décodeur, est perturbée par les conditions de canal (à cause de problèmes radio, de congestion de réseau d'accès, etc.).

Dans ce cas, le décodeur utilise des mécanismes de correction (ou « masquage ») de perte de trames pour tenter de substituer le signal manquant par un signal reconstitué, en utilisant les informations disponibles au sein du décodeur (par exemple le signal déjà décodé ou les paramètres reçus dans des trames précédentes). Cette technique permet de maintenir une bonne qualité de service malgré des performances de canal dégradées.

Les techniques de correction de perte de trames sont le plus souvent très dépendantes du type de codage utilisé.

Dans le cas du codage d'un signal de parole basé sur des technologies de type CELP (pour « Code Excited Linear Prédiction »), la correction de perte de trame exploite en particulier le modèle CELP. Par exemple, dans un codage selon la recommandation G722.2, la solution pour remplacer une trame perdue (ou un «paquet») consiste à prolonger l'utilisation d'un gain de prédiction à long terme en l'atténuant, ainsi qu'à prolonger l'utilisation de chaque paramètre ISF (pour « Imittance Spectral Frequency ») en les faisant tendre vers leurs moyennes respectives. La période de la hauteur tonale du signal de parole (ou « pitch », paramètre désigné « LTP-Lag ») est aussi répétée. Par ailleurs, on fournit au décodeur des valeurs aléatoires de paramètres caractérisant « l'innovation » (l'excitation dans le codage CELP).

Il convient de noter déjà que l'application de ce type de méthode, pour des codages par transformée ou pour des codages de type « PCM » (pour "Pulse Code Modulation"), nécessite un encodage de type CELP au niveau du décodeur ce qui introduit une complexité supplémentaire.

Dans la recommandation UIT-T G711 visant un codeur de formes d'ondes, un traitement de correction de perte de trame (donné en exemple dans la partie Appendice I du texte de cette recommandation) consiste à trouver une période de pitch dans le signal de parole déjà décodé et à répéter la dernière période de pitch par recouvrement-addition (ou « overlap-add » en anglais) entre le signal déjà décodé et le signal répété. Ce traitement permet de « gommer » les artefacts audio mais nécessite un délai supplémentaire au décodeur (délai correspondant à la durée du recouvrement).

La technique la plus employée pour corriger la perte de trame dans le cas d'un codage par transformée consiste à répéter le spectre décodé dans la dernière trame reçue. Par exemple, dans le cas du codage selon la recommandation G.722.1, la transformée MLT (pour « modulated lapped transform »), équivalente à une transformée en cosinus discret modifiée (ou MDCT pour « modified discrète cosine transform ») avec un recouvrement de 50% et des fenêtres de forme sinusoïdale, permet d'assurer une transition (entre la dernière trame perdue et la trame répétée) qui est suffisamment lente pour gommer les artefacts liés à la simple répétition de la trame.

Avantageusement, cette technologie ne nécessite pas de délai supplémentaire puisqu'elle exploite le repliement temporel de la transformée MLT pour faire un recouvrement-addition avec le signal reconstitué. Il s'agit d'une technique très peu coûteuse en termes de ressources.

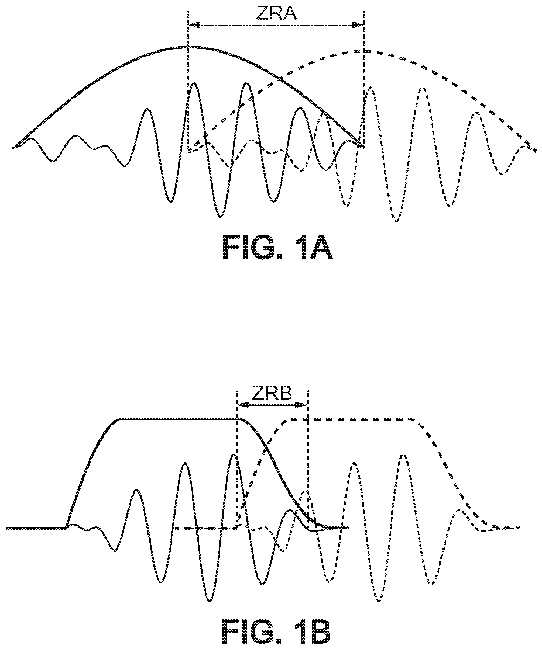

Toutefois, elle présente un défaut lié à l'incohérence temporelle entre le signal juste avant la perte de trame et le signal répété. Il en résulte une discontinuité de phase audible qui peut produire des artefacts audio importants si la durée de recouvrement entre les deux trames est réduite (comme c'est le cas en particulier lorsque des fenêtres MDCT dites « à faible retard » sont utilisées). On a illustré cette situation de durée courte de recouvrement sur la figure 1B dans le cas d'une transformée MLT à faible retard, en comparaison de la situation habituelle de la figure 1A dans laquelle des fenêtres longues en sinus sont utilisées selon la recommandation G.722.1 (offrant alors une grande durée de recouvrement ZRA, avec une modulation très progressive). Il apparait qu'une modulation par une fenêtre à faible retard produit un déphasage qui est audible du fait d'une zone de recouvrement courte ZRB, comme représenté sur la figure 1B.

Dans ce cas, quand bien même une solution combinant une recherche de pitch (cas du codage selon la recommandation G711- Appendice I) et un recouvrement-addition produit par la fenêtre d'une transformée MDCT serait mise en oeuvre, elle ne serait pas suffisante pour supprimer les artefacts audio liés notamment au déphasage.

Une autre technique de correction de perte de trames consiste à générer un signal de synthèse à partir d'une structure de signal extraite d'une période de pitch. On entend par période de pitch, une période fondamentale notamment dans le cas d'un signal de parole voisé (inverse de la fréquence fondamentale du signal). Néanmoins, le signal peut être aussi issu d'un signal de musique par exemple, présentant une tonalité globale à laquelle est associée une fréquence fondamentale, ainsi qu'une période fondamentale qui pourrait correspondre à la période de répétition précitée.

Toutefois, les propriétés physiques du signal de synthèse ne correspondent pas à celle du signal d'origine (dont certaines trames ont été perdues) et sont à l'origine d'imperfections auditives désagréables. Ceci a pour conséquence d'introduire des erreurs supplémentaires par rapport au signal original. De plus, l'énergie du signal correctement reçu et celle du signal reconstruit à partir de la structure décrite ci-avant peuvent être sensiblement différentes. Ces différences peuvent être à l'origine d'une sensation auditive de « saut de bruit », dans laquelle le niveau de bruit change de manière intermittente. Par exemple, pour un signal dans lequel on assimilerait le signal de bruit à un «bruit de fond », l'auditeur devrait supporter des sautes de ce bruit de fond.

On retiendra de manière plus générale que dans l'état de l'art actuel, la génération du signal de synthèse pour combler les trames remplaçant des trames perdues introduit une périodicité qui, sur des signaux complexes tels que de la musique, n'est pas en conformité avec l'étendue de toutes les composantes du signal à remplacer.

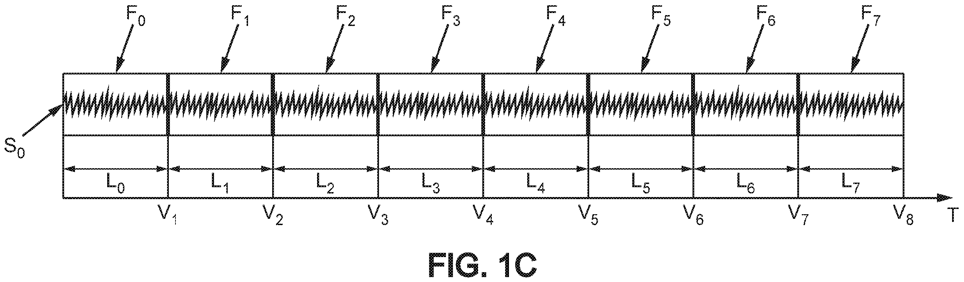

Par exemple, en référence à la figure 1C, un signal $S_0$ est répété 7 fois sur les fenêtres $F_1$ à $F_7$. Les caractéristiques temporelles (instants de début de fenêtre $v_1$ à $v_7$ et durée temporelle de fenêtre $L_0$ à $L_7$) des fenêtres étant identiques, une périodisation est introduite.

Cette périodisation systématique et inadéquate se traduit par un son "métallique" et artificiel (donc gênant pour l'auditeur) à chaque perte de trame. Il convient alors d'améliorer les procédés existants de réplication, notamment mais non limitativement en contexte de décodage avec addition-recouvrement. Des exemples et des modes de réalisation de l'art antérieur peuvent être trouvés dans « Packet loss concealment for voice transmission over IP networks », MAHFUZ E ; « A Linear Prédiction Based Packet Loss Concealment Algorithm for PCM Coded Speech », EMRE GUNDUZHAN et al. ; « Audio Engineering Society Convention Paper Parametric Interpolation of Gaps in Audio Signais », Alexey Lukin et al.

La présente invention vient améliorer la situation.

Elle propose à cet effet un procédé de traitement d'un signal numérique, mis en oeuvre pendant un décodage du signal pour remplacer une succession d'échantillons perdue au décodage,

le procédé comporte les étapes :

- génération d'une structure d'un signal de remplacement de la succession perdue, cette structure comportant des composantes spectrales déterminées à partir d'échantillons valides reçus au décodage et antérieurs à la succession d'échantillons perdue,
- génération d'un résidu entre un signal numérique disponible au décodeur comportant des échantillons valides reçus et un signal généré à partir des composantes spectrales,
- extraction de blocs du résidu.

En particulier, on injecte les blocs dans la structure par additions avec recouvrement suivant des fenêtres de pondération de bloc, les blocs injectés se recouvrant au moins partiellement dans le temps, et dans lequel, lesdits blocs ayant un instant de début de bloc extrait ($i_k$) et une durée de bloc ($L_k$), au moins un paramètre parmi : - ledit instant de début de bloc extrait, - ladite durée de bloc, - un instant de début d'écriture de bloc injecté ($j_k$), et - un taux de recouvrement entre deux blocs injectés successifs, est variable entre au moins deux blocs extraits ou injectés.

Ainsi, l'injection des blocs rend possible un remplissage des trames perdues sans manque d'énergie perceptible. L'injection des blocs homogénéise l'énergie du signal en ce qu'elle rétablit artificiellement la densité spectrale à un niveau constant. L'ensemble des blocs injectés correspond par exemple à un signal de bruit injecté au signal de remplacement. En particulier, les additions avec recouvrement rendent possible un lissage énergétique du signal de bruit sur les zones de transitions.

De plus, l'invention propose de réinjecter les différents blocs extraits, sans périodicité marquée et en évitant ainsi un effet « métallique » audible, lié à une simple répétition du résidu. En particulier, les recouvrements partiels des blocs limitent les effets de périodisation en ce que la transition du signal de bruit entre deux blocs successifs est lissée. En effet, un tel recouvrement rend plus difficilement distinguable le passage d'une période à une autre et, de ce fait, limite les effets de périodisation.

On entend par « structure d'un signal de remplacement », un ensemble de caractéristiques propres au signal de remplacement telles que, par exemple, les composantes spectrales de ce signal, les amplitudes associées à ces composantes spectrales, les phases associées à ces composantes, etc.

Le recouvrement des blocs est au moins partiel car un bloc peut par exemple se retrouver complètement recouvert, mais de façon complémentaire par ses deux blocs voisins. Dans un autre exemple, le premier bloc est complètement recouvert par le début du deuxième.

La structure du signal de remplacement peut comporter, dans une réalisation particulière, des composantes spectrales déterminées à partir d'échantillons valides reçus au décodage et antérieurs à la succession d'échantillons perdue. Ainsi, un signal de remplacement peut être facilement régénéré, notamment sur une durée différente de celle à partir de laquelle les composantes spectrales ont été déterminées.

En outre, le résidu peut être généré à partir d'un résidu entre une partie du signal numérique comportant des échantillons valides reçus et un signal généré à partir des composantes spectrales décrites ci-avant. Ainsi, les blocs extraits de ce résidu sont adaptés au signal à reconstruire en ce qu'on injecte les composantes énergétiques manquantes au signal de remplacement. En effet, les composantes spectrales des blocs injectés correspondent exactement aux composantes spectrales manquantes au signal généré à partir de la structure du signal de remplacement décrite ci-avant. Dès lors, la densité spectrale du signal dans lequel le les blocs sont injectés correspond à la densité spectrale du signal précédent pour lequel des trames ont été correctement reçues. L'énergie du signal se trouve ainsi avantageusement harmonisée (entre les parties du signal correctement reçu et les parties reconstruites).

Les blocs étant déterminés par un instant de début de bloc extrait et une durée de bloc, au moins un paramètre parmi cet instant de début de bloc extrait et cette durée de bloc peut être variable entre au moins deux blocs extraits.

Les blocs sont injectés avec au moins un paramètre variable entre au moins deux blocs injectés, le paramètre variable étant parmi :

- un instant de début d'écriture de bloc injecté, et
- un taux de recouvrement entre deux blocs injectés successifs.

Ainsi, des incohérences sont introduites dans le signal de remplacement des échantillons perdus. La variabilité des paramètres évoqués ci-dessus « dépériodise » le signal. En effet, si ces paramètres varient, le signal ne se répète plus à l'identique après un intervalle de temps constant. Ainsi, les impressions de son métallique provoquées par les répétitions du signal de bruit sont supprimées. Une détermination pseudo-aléatoire, pseudo-aléatoire avec au moins une condition, selon des règles prédéterminées peut par exemple être à l'origine de la variabilité de ces paramètres.

Dans une autre variante au moins un paramètre parmi ceux décrits ci-avant peut être variable de manière pseudo-aléatoire pour au moins un bloc injecté.

On entend par « pseudo-aléatoire », une suite de nombres qui s'approche d'un aléa statistiquement parfait. De par les procédés algorithmiques utilisés pour la générer et les sources employées, la suite ne peut être complètement considérée comme aléatoire. Des conditions peuvent en outre être prises en compte parallèlement à la détermination pseudo-aléatoire d'au moins un paramètre. Par exemple, une moyenne de l'ensemble des paramètres déterminés peut-être fixée. Dans cette situation, par exemple, les paramètres tirés de manière pseudo-aléatoire et ayant pour effet de faire sortir la moyenne d'un intervalle prédéterminé, peuvent être discriminés. Le choix de la variabilité des paramètres (pseudo-aléatoire, pseudo-aléatoire avec condition, règles prédéterminées, etc.) peut lui-même répondre à des conditions telles que par exemple le nombre d'échantillons perdus au décodage, le degré de qualité du signal souhaité par l'utilisateur, les ressources disponibles pour faire les calculs de reconstruction, etc.

Ainsi générés, les paramètres évoqués ci-avant introduisent des incohérences dans le signal de bruit qui rendent imperceptible le caractère artificiel du bruit injecté. L'introduction de paramètres générés de manière pseudo-aléatoire rend très peu probable tout phénomène d'accoutumance de l'oreille à un ordre de répétition du signal de bruit. En effet, aucune logique n'est présente entre les différentes fenêtres de pondérations. Dès lors, un auditeur ne peut être gêné par une impression de répétition du signal de bruit (par exemple un bruit de fond).

Dans un autre mode de réalisation, les paramètres évoqués ci-avant pour l'extraction des blocs et/ou pour l'injection des blocs sont fixés à l'avance. Ainsi, on a recours à des blocs prédéfinis ce qui simplifie les calculs et réduit ainsi le temps de traitement tout en sollicitant moins le ou les processeurs utilisés pour ces calculs.

Dans un mode de réalisation, la somme des fenêtres de pondération appliquées à deux blocs successifs injectés est égale à un sur le segment de recouvrement entre ces deux blocs. Ainsi, l'amplitude du signal de remplacement est constante et aucun artefact de transition entre deux blocs ne vient perturber le signal.

Dans un autre mode de réalisation, la somme des carrés des fenêtres de pondération appliquées à deux blocs successifs injectés est égale à un sur le segment de recouvrement entre ces deux blocs. Ainsi, l'énergie du signal de remplacement est constante et l'énergie du signal est temporellement constante.

Dans un mode de réalisation, on peut modifier le signe d'au moins un bloc injecté. Le choix du bloc à inverser est par exemple déterminé de manière pseudo-aléatoire, pseudo-aléatoire avec au moins une condition (modification d'un nombre maximum de fenêtres par exemple) ou par une règle prédéterminée (une fenêtre sur deux, toutes les fenêtres d'une certaine longueur, etc.). Ainsi, des incohérences supplémentaires sont ajoutées au signal de bruit. De plus, cet ajout d'incohérence se fait sans augmenter la complexité des étapes de génération du signal de remplacement. En effet, l'inversion du signal de bruit ne requiert pas d'importantes ressources de calcul et cela réduit ainsi le temps de traitement tout en sollicitant moins le ou les processeurs utilisés pour ces calculs.

Dans une variante, on retourne temporellement au moins un bloc injecté.

On entend par « retourne temporellement » une application à un bloc b dépendant du temps t sur une fenêtre de pondération [DF ; FF], d'une formule de type : $b(t)= b(FF+DF-t)$. Ainsi, on introduit de nouvelles incohérences au signal de remplacement.

Dans un autre mode de réalisation, les blocs sont d'abord injectés dans un signal de bruit intermédiaire, ce signal de bruit intermédiaire étant lui-même ultérieurement injecté à la structure lorsque tous les blocs ont été injectés dans le signal de bruit intermédiaire. Ainsi, le signal de bruit à injecter au signal de remplacement est entièrement généré avant d'être injecté. Ceci rend notamment possible la mise en place de mécanismes de vérification du signal de bruit intermédiaire avant qu'il soit injecté au signal de remplacement.

Dans une variante, les blocs sont injectés en temps réel sans attendre que la totalité d'un signal de bruit intermédiaire soit généré. On entend alors par injection « en temps réel », une injection des blocs à une vitesse adaptée à l'évolution temporelle du signal. Dans cette situation, l'écart temporel entre le signal reçu par le décodeur et le signal restitué à l'oreille de l'auditeur est le plus faible possible. Par exemple, une structure de signal de remplacement est générée au début de la succession d'échantillons perdue au décodage puis les blocs sont injectés au fur et à mesure de la progression temporelle du signal, sans qu'un signal de bruit intermédiaire soit entièrement généré puis lui-même injecté au signal de remplacement.

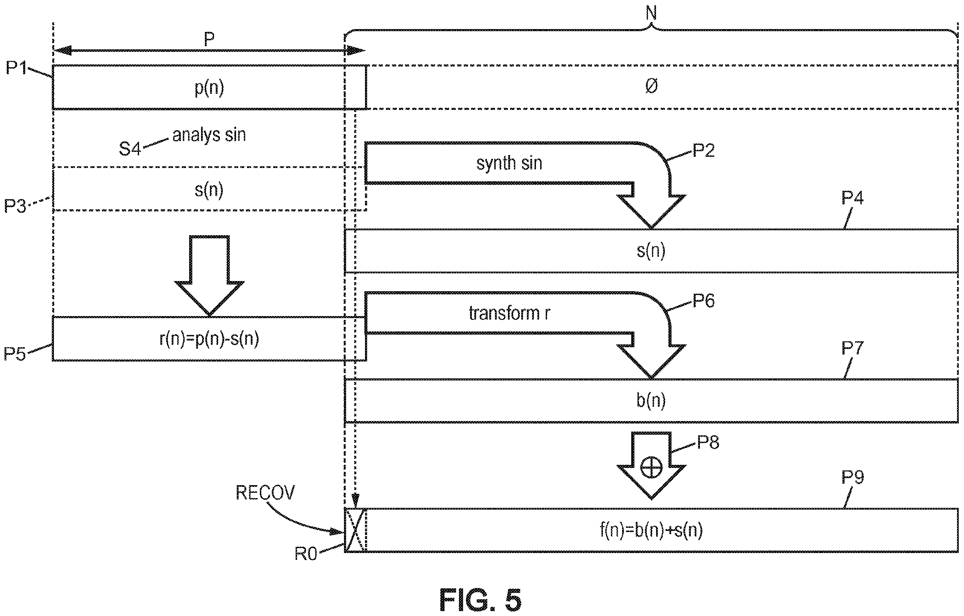

L'invention vise aussi un programme informatique comportant des instructions pour la mise en oeuvre du procédé ci-avant. Par exemple, l'une et/ou l'autre des figures 5 à 8 peut constituer un algorithme général d'un tel programme informatique.

L'invention peut être mise en oeuvre par un dispositif de décodage d'un signal comportant une succession d'échantillons répartis en trames successives, le dispositif comportant des moyens pour remplacer au moins une trame de signal perdue, comportant des moyens de :

- génération d'une structure d'un signal de remplacement de la succession perdue, la structure comportant des composantes spectrales déterminées à partir d'échantillons valides reçus au décodage et antérieurs à la succession d'échantillons perdue,
- génération d'un résidu entre un signal numérique disponible au décodeur comportant des échantillons valides reçus et un signal généré à partir des composantes spectrales,
- extraction de blocs du résidu,
- injection des blocs dans la structure,

dans lequel les moyens d'injection mettent en oeuvre des additions avec recouvrement suivant des fenêtres de pondération de blocs, les blocs injectés se recouvrant au moins partiellement dans le temps,
et dans lequel, lesdits blocs ayant un instant de début de bloc extrait ($i_k$) et une durée de bloc ($L_k$), au moins un paramètre parmi : - ledit instant de début de bloc extrait, - ladite durée de bloc, - un instant de début d'écriture de bloc injecté ($j_k$), et - un taux de recouvrement entre deux blocs injectés successifs, est variable entre au moins deux blocs extraits ou injectés.

Un tel dispositif peut prendre la forme matérielle par exemple d'un processeur et éventuellement d'une mémoire de travail, typiquement dans un terminal de communication.

D'autres avantages et caractéristiques de l'invention apparaîtront à la lecture de la description détaillée ci-après d'exemples de réalisation de l'invention et à l'examen des dessins sur lesquels :

- la figure 1A illustre un recouvrement avec des fenêtres classiques dans le cadre d'une transformée MLT,
- la figure 1B illustre un recouvrement avec des fenêtres à faible retard, en comparaison de la représentation de la figure 1A,
- la figure 1C illustre une réplication périodique d'un signal de bruit,
- la figure 2 représente un exemple du cadre technique dans lequel la présente invention peut être mise en oeuvre,
- la figure 3 représente schématiquement un dispositif comportant des moyens de mise en oeuvre du procédé au sens de l'invention,
- la figure 4 représente un exemple de traitement général au sens de l'invention,
- la figure 5 illustre schématiquement les étapes d'un procédé au sens de l'invention, dans un exemple de réalisation,
- la figure 6 illustre schématiquement les étapes d'un procédé au sens de l'invention, dans un autre exemple de réalisation,
- la figure 7 illustre schématiquement les étapes d'un procédé au sens de l'invention, dans un autre exemple de réalisation,
- la figure 8 illustre schématiquement les étapes d'un procédé au sens de l'invention, dans un autre exemple de réalisation,
- la figure 9A représente des fenêtres successives de pondération au sens de l'invention pour un taux de recouvrement constant, déterminées selon un mode de réalisation,
- la figure 9B représente des fenêtres successives de pondération au sens de l'invention pour un taux de recouvrement constant, déterminées selon un mode de réalisation,
- la figure 9C représente des fenêtres successives de pondération au sens de l'invention pour un taux de recouvrement constant, déterminées selon un mode de réalisation,

- la figure 10 représente des fenêtres successives de pondération au sens de l'invention pour un taux de recouvrement pseudo-aléatoire, déterminées selon un mode de réalisation,
- la figure 11 représente des fenêtres successives de pondération au sens de l'invention, déterminée selon un mode de réalisation.

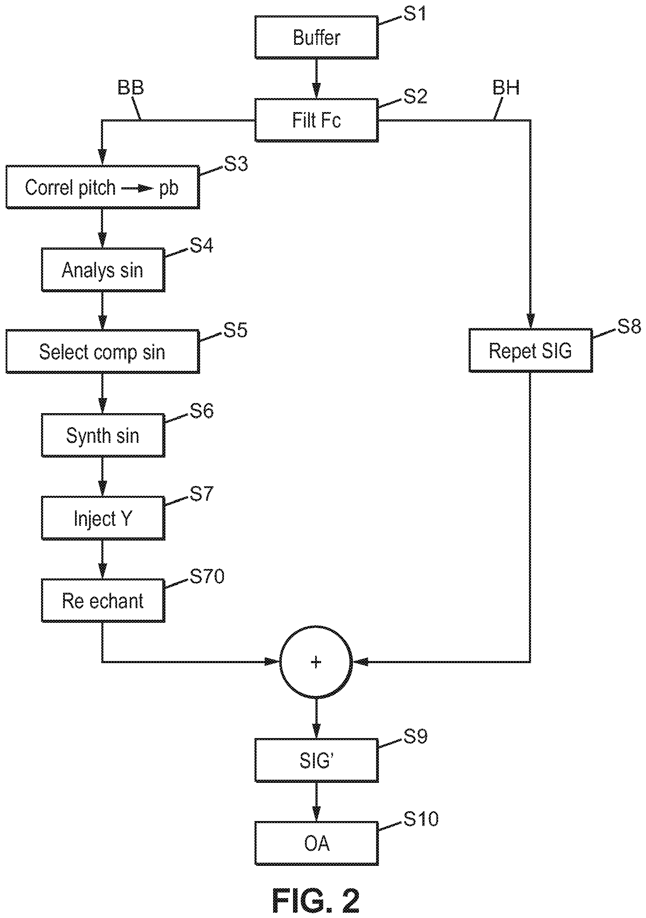

On se réfère à la figure 2 pour décrire un contexte avantageux mais optionnel, de mise en oeuvre de la présente invention. Il s'agit d'un traitement qui est mis en oeuvre auprès d'un décodeur de signal reçu. Le décodeur peut être de type quelconque, le traitement étant globalement indépendant de la nature du codage/décodage. Dans l'exemple décrit, le traitement s'applique à un signal audio reçu. Il peut s'appliquer toutefois de façon plus générale à tout type de signal analysé par fenêtrage temporel et transformation, avec une harmonisation à assurer avec une ou plusieurs trames de remplacement lors d'une synthèse par recouvrement-addition.

On entend par « trame » un bloc d'au moins un échantillon. Dans la plupart des codecs, ces trames sont constituées de plusieurs échantillons. Toutefois, dans des codecs notamment de type PCM (pour « Puise Code Modulation »), par exemple selon la recommandation G.711, le signal est constitué simplement d'une succession d'échantillons (une « trame » au sens de l'invention ne comportant alors qu'un unique échantillon). L'invention peut alors aussi s'appliquer à ce type de codecs.

Par exemple, le signal valide peut être constitué des dernières trames valides reçues avant la perte de trame. Eventuellement, on peut avoir recours aussi à une ou quelques trames valides suivantes, reçues après la trame perdue (bien qu'une telle réalisation entraîne un retard au décodage). Les échantillons du signal valide qui sont utilisés peuvent être directement ceux des trames, et éventuellement ceux qui correspondent à la mémoire de la transformée et qui contiennent typiquement un repliement (ou « aliasing ») dans le cas d'un décodage par transformée avec recouvrement de type MLT ou MDCT.

Au cours d'une première étape S1 du traitement de la figure 2, N échantillons audio sont stockés successivement dans une mémoire tampon ou « buffer » (par exemple de type FIFO). Ces échantillons correspondent à des échantillons déjà décodés et donc accessibles au moment du traitement de correction de perte de trame(s). Si le premier échantillon à synthétiser est l'échantillon d'indice temporel N (d'une ou plusieurs trames consécutives perdues), le buffer audio b(n) correspond alors aux N échantillons précédents d'indices temporels 0 à N-1.

A l'étape de filtrage S2, le buffer audio b(n) est ensuite séparé en deux bandes de fréquences, une bande de fréquences basses BB et une bande de fréquences hautes BH avec une fréquence de séparation notée Fc ci-après, avec par exemple Fc=4kHz.

L'étape S3, appliquée sur la bande de fréquences basses, consiste à rechercher ensuite un point de bouclage et un segment de longueur P correspondant à la période fondamentale au sein du buffer b(n) ré-échantillonné avec la fréquence Fc. La période fondamentale correspond par exemple à une période de pitch dans le cas d'un signal de parole voisé (inverse de la fréquence fondamentale du signal). Néanmoins, le signal peut être aussi issu d'un signal de musique par exemple, présentant une tonalité globale à laquelle est associée une fréquence fondamentale, ainsi qu'une période fondamentale qui pourrait correspondre à la période de répétition précitée.

Dans ce qui suit, on présume qu'une seule période fondamentale de longueur P sert à la synthèse du signal, mais il convient de noter toutefois que le principe du traitement s'applique aussi bien pour un segment s'étendant sur plusieurs périodes fondamentales. Les résultats s'avèrent même meilleurs avec plusieurs périodes fondamentales, en termes de précision sur la transformée FFT et de richesse sur les composantes spectrales obtenues.

L'étape suivante S4 consiste à décomposer le segment p(n) en une somme de sinus.

A l'étape S5 de la figure 2, les composantes sinusoïdales sont sélectionnées de manière à ne garder que les composantes les plus importantes.

L'étape suivante S6 vise une synthèse sinusoïdale. Dans un exemple de réalisation, elle consiste à générer un segment s(n) de longueur au moins égale à la taille d'une trame perdue (T). Dans un mode de réalisation particulier, une longueur égale à 2 trames (par exemple 40 ms) est générée de manière à pouvoir effectuer un mixage sonore de type « fondu enchainé » (comme une transition) entre le signal synthétisé (par correction de perte d'une trame) et le signal décodé à la trame valide suivante lorsqu'une telle trame est à nouveau reçue correctement.

Pour anticiper le ré-échantillonnage de la trame (longueur d'échantillons notée LF), le nombre d'échantillons à synthétiser peut être augmenté de la moitié de la taille du filtre de ré-échantillonnage (LF). Le signal de synthèse s(n) est calculé comme une somme des composantes sinusoïdales sélectionnées :

$$s(n) = \sum_{k=0}^{k=K} A(k) \sin(\pi f(k)\, n + \varphi(k)) \quad n \in \left[0;\ 2T + \frac{LF}{2}\right]$$

où k est l'indice des K composantes sélectionnées de l'étape S5. Plusieurs méthodes classiques pour réaliser cette synthèse sinusoïdale sont possibles.

L'étape S7 de la figure 2 consiste à injecter du bruit de manière à compenser la perte d'énergie liée à l'omission de certaines composantes fréquentielles dans la bande de fréquences basses.

Un mode de réalisation simple de la présente invention peut déjà être décrit en référence à la figure 5. Il consiste à calculer le résidu r(n)=p(n)-s(n) à l'étape P5 entre le bloc de signal p(n) correspondant au pitch extrait à l'étape P1 et le signal synthétisé s(n) généré à l'étape P3 à partir de l'analyse sinusoïdale faite à l'étape S4, avec : $n \in [0; P - 1]$.

Ce résidu est transformé à l'étape P6 de manière à ce qu'il atteigne une taille $2T + \frac{LF}{2}$, pour devenir le signal b(n) à l'étape P7.

Le signal b(n) est ensuite injecté, à l'étape P8, au signal s(n) généré à l'étape P2 sur une durée N correspondante à la durée du signal à remplacer.

Ce signal de remplacement f(n) est ensuite mixé au signal valide à une étape P9. Le mixage peut par exemple comprendre une addition avec recouvrement RECOV sur un intervalle de recouvrement RO.

Dans un mode de réalisation, ce signal résidu est répliqué une ou plusieurs fois (selon la portion temporelle à remplir) avec addition-recouvrement entre répliques.

Dans un autre mode de réalisation, diverses transformations peuvent être opérées sur les blocs du signal résiduel d'une manière pseudo-aléatoire à chaque réplication : on peut ainsi inverser le signe du signal, et/ou opérer un retournement temporel.

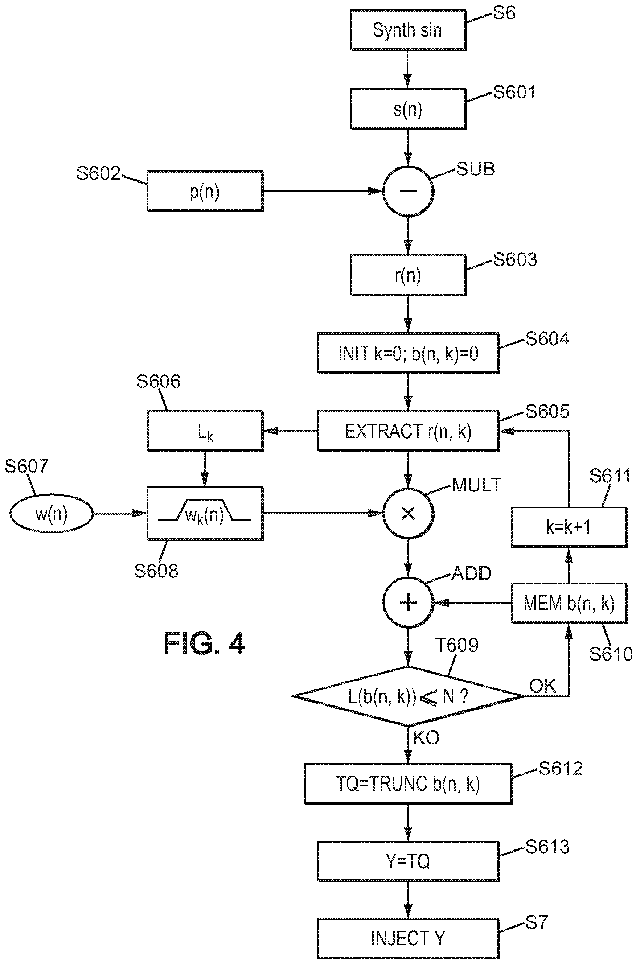

On décrit maintenant en référence à la figure 4, un procédé de génération d'un signal de bruit à injecter à une structure d'un signal de remplacement, selon un mode de réalisation de l'invention.

A l'étape S601, un signal s(n) est généré à partir de la synthèse sinusoïdale de l'étape S6 (également référencée à la figure 2) sur une durée correspondant à celle du bloc p(n) extrait à l'étape S602.

Le résidu r(n) est obtenu par la soustraction SUB du signal s(n) au signal p(n). Ainsi, on dispose, à l'étape S603, de r(n) tel que r(n)=p(n)-s(n).

A l'étape S604, une variable de comptage k est initialisée à 0 et le signal b(n,k) est initialisé de tel sorte que b(n,0)=0.

A l'étape S605, un bloc r(n,k) est extrait du signal r(n). Dans un mode de réalisation, les caractéristiques temporelles (instant de début de bloc $i_k$ et durée temporelle du bloc $L_k$) de cette extraction sont déterminées de manière pseudo-aléatoire. Dans un autre mode de réalisation, des conditions peuvent être imposées pour cette extraction. Par exemple, la somme de la valeur de l'instant de début de bloc et de la valeur de la durée temporelle doit être inférieure à la valeur de la durée correspondant à celle du bloc p(n) extrait à l'étape S602.

A l'étape S606, la durée temporelle $L_k$ du bloc r(n,k) extrait est transmise pour une étape de configuration de fenêtre S608.

A l'étape S607, un ensemble de fenêtres de pondération est rendu disponible pour qu'une fenêtre de pondération soit configurée à l'étape S608. Par exemple, les fenêtres de pondération stockées dans une mémoire de stockage sont extraites et transférées dans une mémoire de travail.

A l'étape S608, une fenêtre de pondération est sélectionnée et paramétrée pour qu'elle puisse être multipliée au bloc r(n,k) à l'étape MULT. La fenêtre a notamment pour paramètres la durée temporelle $L_k$ approprié au bloc r(n,k).

Le bloc $w_k$.r(n,k) est ensuite additionné avec recouvrement au signal b(n,k-1), correspondant aux (k-1) blocs déjà additionnés, tel que b(n,k)=$w_k$.r(n,k)+b(n,k-1). Dans un mode de réalisation, l'addition avec recouvrement est effectuée avec un taux de recouvrement fixe de 50%.

Au test T609, on vérifie que la longueur du signal b(n,k) déjà généré n'est pas supérieure à la valeur N correspondante à la durée du signal à remplacer.

Si oui, le signal b(n,k) est tronqué de manière à ce que la longueur temporelle de b(n,k) soit égale à la valeur N correspondant à la durée du signal à remplacer à l'étape S612, la valeur tronquée est notée TQ. A l'étape S613, le signal de bruit Y à injecter au signal de remplacement de trames perdues est fixé à TQ et est injecté à l'étape S7 (également référencé à la figure 2).

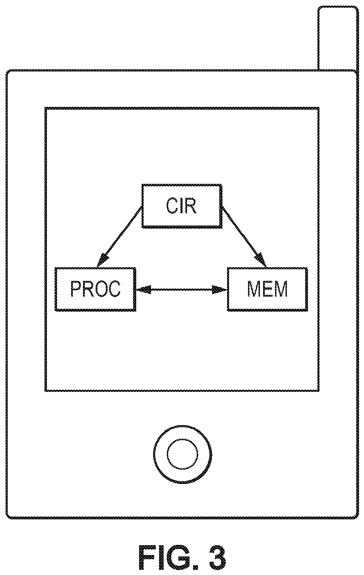

Si non, la valeur de b(n,k) est stockée dans une mémoire de travail MEM (en référence à la figure 3) pour être ultérieurement ajoutée au bloc suivant r(n,k+1). A l'étape S611, la variable de comptage k est incrémentée et le procédé reprend à l'étape S605.

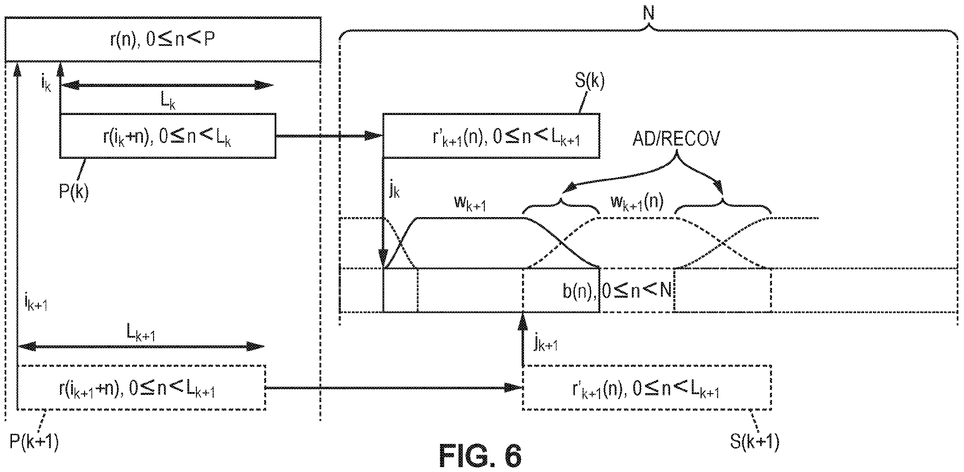

On décrit maintenant en référence à la figure 6, un procédé de génération d'un signal de bruit à injecter à une structure d'un signal de remplacement, selon un autre mode de réalisation de l'invention.

Dans ce mode de réalisation, l'injection de signal résiduel se fait par itérations successives (numérotées *k*) d'additions-recouvrements de blocs de signal $r'_k(n)$ obtenus à partir du résidu r(n).

A l'itération *k*, on détermine le bloc lu par un indice de début de bloc $i_k$ et une longueur de bloc $L_k$, et l'on définit la manière d'injecter cette portion de résidu dans le segment temporel ciblé en déterminant une transformation optionnelle $T_k$, un indice d'écriture $j_k$ (début de copie du bloc au sein du segment temporel à remplir), et une fenêtre d'addition-

recouvrement $w_k(n)$.

Notons $b(n)$ le signal complémentaire, de taille $N$ échantillons, à générer à partir du résidu. La procédure de génération du signal de bruit se décrit comme suit.

**Initialisation :**

$$b(n) = 0, \ 0 \leq n < N$$

$$k = 0$$

$$j_0 = 0$$

**Itérations,** jusqu'à ce que $j_k + L_k = N$ :

1) choix de $i_k$ et $L_k$ tels que $i_k + L_k \leq P$ et $j_k + L_k \leq N$, et extraction du bloc P(k),

2) choix d'une transformation $T_k$ pour obtenir S(k) correspondant à $r_k'(n) = T_k\big(r_k(i_k + n)\big)$. Cette transformation est décrite ci-après,

3) si $j_k + L_k < N$, pour préparer le chevauchement avec l'itération suivante, choix de $j_{k+1} \leq j_k + L_k$ (et de préférence $j_{k+1} \geq j_{k-1} + L_{k-1}$ pour limiter le chevauchement simultané à deux blocs, par exemple S(k) et S(k+1), au plus), et extraction du bloc P(k+1),

4) détermination de la fenêtre de pondération $w_k(n)$ en fonction des chevauchements éventuels avec des blocs voisins,

5) collage de $r_k'(n)$ pondéré par la fenêtre $w_k(n)$ : $\ b(j_k + n) = b(j_k + n) + r_k'(n).w_k(n), 0 \leq n < L_k$, et

6) incrémentation $k = k + 1$.

Dans ce mode de réalisation, la procédure décrite fait progresser l'indice d'écriture $j_k$ de façon croissante. Tout autre choix de progression (décroissante, non-monotone, etc.) est également possible.

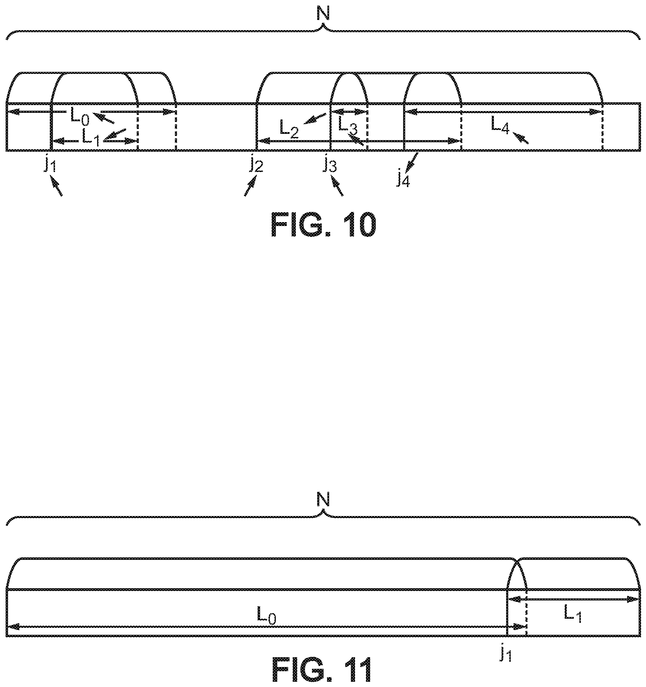

Dans un autre mode de réalisation, on choisit $L_k$ relativement grand par rapport à la réserve disponible P, pour pouvoir progresser de façon significative dans la copie, et éviter de distordre des composantes relativement basses fréquences. Par exemple, en référence à la figure 11, $L_0$ est choisi relativement grand de sorte qu'une seule addition avec recouvrement soit appliquée.

Dans un autre mode de réalisation, la taille $j_k + L_k - j_{k+1}$ des zones de recouvrement est réduite pour limiter la quantité d'opérations d'addition et multiplication induites. Le réglage du taux de recouvrement (correspondant à la taille $j_k + L_k - j_{k+1}$ des zones de recouvrement) peut également être paramétré pour que le rapport entre qualité (gommage des artefacts) et coût de traitement soit adapté à l'utilisation prévue du décodeur.

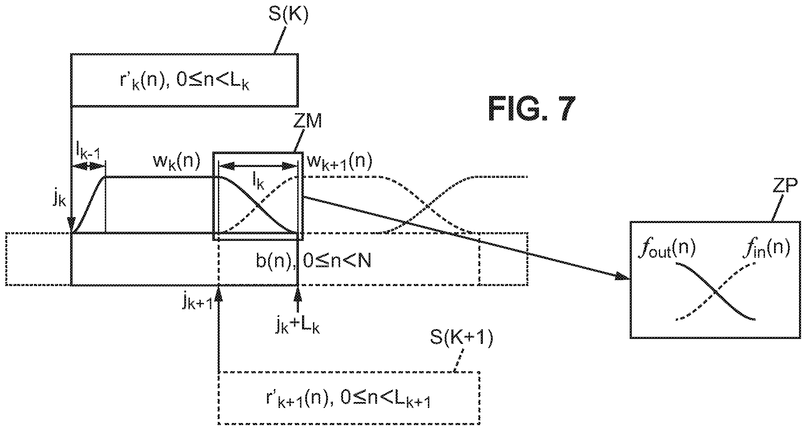

Dans un mode de réalisation préférentiel, en référence à la figure 7, les fenêtres de pondération sont déterminées pour assurer une transition douce entre les portions collées ainsi qu'une continuité en termes d'énergie du signal résultant. Typiquement, un maximum de deux blocs se chevauchant en tous points est prévu. Considérons ainsi le chevauchement entre les blocs S(k) et S(k+1). L'encadré ZP représente un agrandissement de l'encadré ZM sur la figure 7.

Sur la zone de chevauchement, soit pour $n \in [0; l_k[$, avec $l_k = j_k + L_k - j_{k+1}$, le signal résultant est :

$$b(j_{k+1} + n) = r_k'(j_{k+1} - j_k + n).w_k(j_{k+1} - j_k + n) + r_{k+1}'(n).w_{k+1}(n)$$

Dans un mode de réalisation, on s'assure que la fin de $w_k$ et le début de $w_{k+1}$ se combinent selon un critère dit « de préservation d'amplitude » :

$$w_k(j_{k+1} - j_k + n) + w_{k+1}(n) = 1$$

Ainsi, il suffit de choisir une fonction de « fondu-enchaîné » $f_{l_k}(n)$, typiquement croissante et bornée par 0 et 1, et d'en déduire pour $n \in [0; l_k[$ :

- $w_k(j_{k+1} - j_k + n) = f_{out}(n) = 1 - f_{l_k}(n)$, et
- $w_{k+1}(n) = f_{in}(n) = f_{l_k}(n)$.

Par exemple, la fonction de fondu-enchaîné peut être affine et définie par : $f_{l_k}(n) = \frac{n+0.5}{l_k}$

Dans un autre exemple, représenté par la fonction $f_{in}(n)$ sur la figure 7, la fonction de fondu-enchaîné peut être de type sinusoïdal et définie par : $f_{l_k}(n) = \left( \sin\left( \frac{n+0.5}{l_k} \frac{\pi}{2} \right) \right)^2$

Dans un autre mode de réalisation, on choisit un critère dit « de préservation d'énergie », où les signaux collés peuvent se combiner sans cohérence de phase, et défini par :

$$\left( w_k(j_{k+1} - j_k + n) \right)^2 + \left( w_{k+1}(n) \right)^2 = 1$$

A partir d'une fonction de fondu-enchaîné $f_k(n)$ telle que proposée ci-avant, on peut alors déduire pour $n \in [0; l_k[$ :

- $w_k(j_{k+1} - j_k + n) = f_{out}(n) = \sqrt{1 - f_{l_k}(n)}$, et

- $w_{k+1}(n) = f_{in}(n) = \sqrt{f_{l_k}(n)}$.

Chaque fenêtre de pondération est typiquement composée de trois parties, de gauche à droite :

- une partie croissante (complémentaire de la partie décroissante de la fenêtre précédente),
- une partie constante et conservatrice (gain de 1), et
- une partie décroissante.

Dans un mode de réalisation, l'une au moins de ces parties est de taille nulle pour au moins une fenêtre de pondération. Par exemple, la fenêtre de pondération appliquée au premier bloc injecté est constituée seulement d'une partie décroissante s'il y a recouvrement complet de ce premier bloc par le début du bloc injecté suivant.

Dans un autre mode de réalisation, on gère simultanément l'effet de fondu-enchaîné de deux blocs sur leur zone de chevauchement. Il s'agit donc simplement de décomposer et rassembler différemment les étapes décrites ci-avant.

Chaque itération se compose alors :

- d'une phase de collage sans chevauchement et donc sans fenêtrage (on évite la multiplication par $w_k(n) = 1$), et/ou
- d'une phase de collage fondu-enchaîné de la fin de l'ancien bloc et du début du nouveau bloc, en utilisant des fonctions de fondu-enchaîné $f_{out}(n)$ et $f_{in}(n)$ décrites ci-avant.

Ceci est décrit plus en détail avec la procédure ci-après, dite « avec fondu-enchaîné simultané ».

**Initialisation** :

- $b(n) = 0$, $0 \le n < N$
- $k = 0$
- $j_0 = 0$
- $l_{-1} = 0$
- Choix de $i_0$ et de $L_0$ tels que $i_0 + L_0 \le P$ et $j_0 + L_0 \le N$
- Choix de $j_1 \ge j_0$ avec $j_1 \le j_0 + L_0$, dont on déduit la taille de chevauchement $l_0 = j_0 + L_0 - j_1$
- Choix des transformations $T_0$ et $T_1$
- Calcul de $r'_0 = T_0(r_0(i_0 + n))$

**Itérations,** jusqu'à ce que $j_k + L_k = N$ :

1) Si $j_{k+1} > j_k + l_{k-1}$, collage sans chevauchement ni fenêtrage :

$$b(j_k + n) = r'_k(n), \quad l_{k-1} \leq n < L_k - l_k$$

2) Collage fondu-enchaîné sur la zone de recouvrement :

$$b(j_{k+1} + n) = r'_k(L_k - l_k + n).f_{\text{out}}(n) + r'_{k+1}(n).f_{\text{in}}(n), \qquad 0 \leq n < l_k$$

3) Si autre itération requise (notamment si $j_k + L_k < N)$,

  a) choix de $j_{k+1} \leq j_k + L_k$ avec $j_{k+1} \geq j_{k-1} + L_{k-1}$ (pour limiter le chevauchement simultané à deux blocs au plus)
  b) Choix de $i_{k+1}$ et $L_{k+1}$ tels que $i_{k+1} + L_{k+1} \leq P$ et $j_{k+1} + L_{k+1} \leq N$
  c) Choix de la transformation $T_{k+1}$ pour obtenir $r'_{k+1}(n) = T_{k+1}\big(r_{k+1}(i_{k+1} + n)\big)$ (voir détails plus bas)

4) Incrémentation $k = k + 1$

Dans une variante, on applique le principe de fondu-enchaîné entre le nouveau bloc collé et le signal déjà généré sur la partie chevauchante: $b(j_{k+1} + n) = b(j_{k+1} + n)f_{\text{out}}(n) + r'_{k+1}(n).f_{\text{in}}(n)$. Ce mode de réalisation a l'avantage de gérer les chevauchements simultanés de plus de deux blocs sans augmenter la complexité des calculs.

Ainsi, au moins l'un des paramètres $i_k$, $j_k$, $L_k$ et $T_k$ varie d'une itération à l'autre, ceci afin d'éviter un effet de périodicité et des artefacts auditifs associés (son métallique, artificiel).

On peut déduire des indices $i_k$, $i_{k+1}$, $j_k$ et $j_{k+1}$ une information de retard $d_{k,k+1}$ d'un bloc collé par rapport à l'autre, dans le segment temporel rempli : $d_{k,k+1} = (j_{k+1} - i_{k+1}) - (j_k - i_k)$.

De manière préférentielle mais non limitative, on fixe $d_{k,k+1}$ de sorte qu'il soit différent d'une itération $k$ à la suivante $k + 1$.

Dans un mode de réalisation, pour améliorer le gommage d'artefacts, des transformations (notées ci-avant $T_k$), simples ou plus complexes, peuvent être introduites de façon variable au cours des itérations, avec l'avantage d'introduire une forme de décorrélation entre les portions de signal injectées.

Une transformation $T_k$ possible et simple consiste à changer le signe du signal $r'_k(n) = T_k(r_k(i_k + n)) = \sigma_k r_k(i_k + n)$ où $\sigma_k = \pm1$ selon l'itération.

Une transformation possible, combinable à la précédente et applicable de façon pseudo-aléatoire, consiste en un retournement temporel, c'est-à-dire à lire ou écrire le résidu de façon rétrograde, tel que :

$$r'_k(n) = T_k\big(r_k(i_k + n)\big) = \sigma_k r_k(i_k + L_k - 1 - n), 0 \leq n < L_k$$

D'autres transformations, plus complexes en coût de calcul, sont également envisageables, par exemple des filtres déphaseurs. Un filtre déphaseur, également appelé filtre « passe-tout » ou cellule correctrice de phase, présente un gain identique sur toute la plage de fréquence utilisée, mais la phase relative des fréquences qui composent le signal varie selon la fréquence.

Bien qu'une variable intermédiaire $r'_k(n)$ soit ici introduite pour faciliter la description, la transformation $T_k$ en question peut se réaliser en tant que mode de lecture particulier des échantillons numériques, sans requérir nécessairement de stockage intermédiaire dans une mémoire tampon entre la lecture dans $r(n)$ et l'écriture dans $b(n)$.

Dans un autre mode de réalisation, la $k^{ème}$ portion de signal injectée peut être obtenue à partir du signal complémentaire déjà généré $b(n)$, $0 \leq n < j_{k-1} + L_{k-1}$, et non plus seulement à partir du seul résidu $r(n)$.

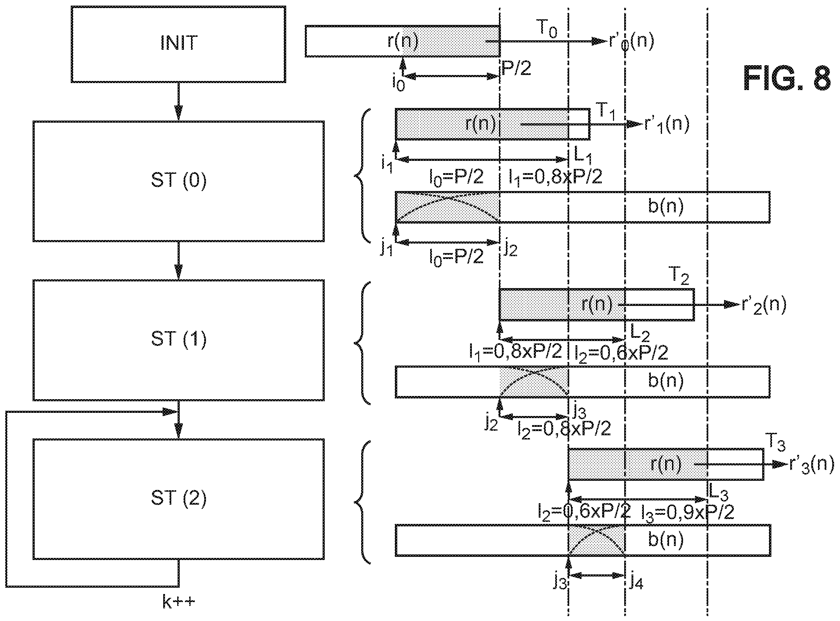

Une variante du mode de réalisation comprenant la procédure « avec fondu-enchaîné simultané » décrite ci-avant, intégrée dans un décodeur audionumérique, est donnée maintenant à titre d'exemple, en référence à la figure 8.

**Initialisation** :

- $j_1 = j_0 = 0$ : le fondu-enchaîné de deux blocs s'applique dès le début du remplissage
- $i_0 = P/2$

- $L_0 = P/2$

**A chaque itération**

- L'indice de lecture $i_k$ (pour k>0) pointe au début du segment de résidu calculé $r(n)$ : $i_k = 0$.
- Les fonctions de fondu enchainé sont de type sinusoïdal :

  • $f_{out}(n) = 1 - f_{l_k}(n)$

  • $f_{in}(n) = f_{l_k}(n)$ avec $f_{l_k}(n) = \left(\sin\left(\frac{n+0.5}{l_k} \cdot \frac{\pi}{2}\right)\right)^2$.

- Il y a recouvrement simultané de deux blocs, donc : $j_{k+1} = j_k + l_{k-1} = j_{k-1} + L_{k-1}$ pour $k > 0$.
- La taille complète de chaque bloc collé correspond au cumul de deux zones de recouvrement conjointes $L_k = l_{k-1} + l_k$, et c'est alors la taille $l_k$ de la zone de recouvrement que l'on détermine à chaque itération, et dont on déduit $L_k$ ainsi que $j_{k+1}$. Ce paramètre $l_k$ est calculé en proportion de la demi-taille P/2 du résidu disponible, tel que :

$$l_k = \lfloor \alpha(k') \cdot P/2 \rfloor$$

avec $k' = mod(k + cnt\_bfi)$ où $cnt_{bfi}$ est le compteur du nombre de trames manquantes et $\alpha$ = [1 0.8 0.6 0.9].
- La transformation $T_k$ se résume un changement de signe occasionnel (pas de retournement temporel), indiqué par

  le coefficient $\sigma_k = \begin{cases} 1 \text{ pour k pair} \\ -1 \text{ pour k impair} \end{cases}$.

Les premières étapes du procédé décrit ci-dessus sont présentées dans le tableau ci-après, en référence à la figure 8. L'étape INIT correspond à l'initialisation de ce procédé et les étapes ST(0), ST(1) et ST(2) aux premières incrémentations du procédé.

| INIT | $j_1=j_0=0$; $l_0=P/2$; $L_0=P/2$; $l_0=P/2$; calcul de $r'_0(n)$ par application de $T_0(\sigma_0=1)$ |
|---|---|
| ST(0) | pour k=0, on choisit : $l_1=0$; $l_1=0.8xP/2$; $L_1=l_1+l_0$ calcul de $r'_1(n)$ par application de $T_1(\sigma_1=-1)$ calcul de $f_{out}(n)$ et $f_{in}(n)$ $b(j_1+n)=r'_0(n)*f_{out}(n)+r'_1(n)*f_{in}(n)$ $j_2=j_1+l_0$ |
| ST(1) | pour k=1, on choisit: $l_2=0$; $l_2=0.6xP/2$; $L_2=l_2+l_1$ calcul de $r'_2(n)$ par application de $T_2(\sigma_2=1)$ calcul de $f_{out}(n)$ et $f_{in}(n)$ $b(j_2+n)=r'_1(L_1-l_1+n)*f_{out}(n)+r'_2(n)*f_{in}(n)$ $j_3=j_2+l_1$ |
| ST(2) | pour k=2, on choisit : $l_3=0$; $l_2=0.9xP/2$; $L_3=l_3+l_2$ calcul de $r'_3(n)$ par application de $T_3(\sigma_3=-1)$ calcul de $f_{out}(n)$ et $f_{in}(n)$ $b(j_3+n)=r'_2(L_2-l_2+n)*f_{out}(n)+r'_3(n)*f_{in}(n)$ $j_4=j_3+l_2$ |

Une fois le signal complémentaire *b(n)* généré sur la portion temporelle voulue, il est additionné au signal généré par synthèse sinusoïdale s(n), n>0.

Dans un mode de réalisation préférentiel, au moins un des paramètres des blocs est déterminé de manière pseudo-aléatoire afin d'introduire des incohérences dans le signal de remplacement et ainsi limiter le phénomène de périodicité à l'origine de désagréments auditifs. Les paramètres des fenêtres de pondération sont par exemple l'instant de début de bloc extrait, la durée temporelle d'un bloc (assimilable notamment au paramètre $L_k$ décrit ci-avant) et le taux de recouvrement de deux blocs successifs.

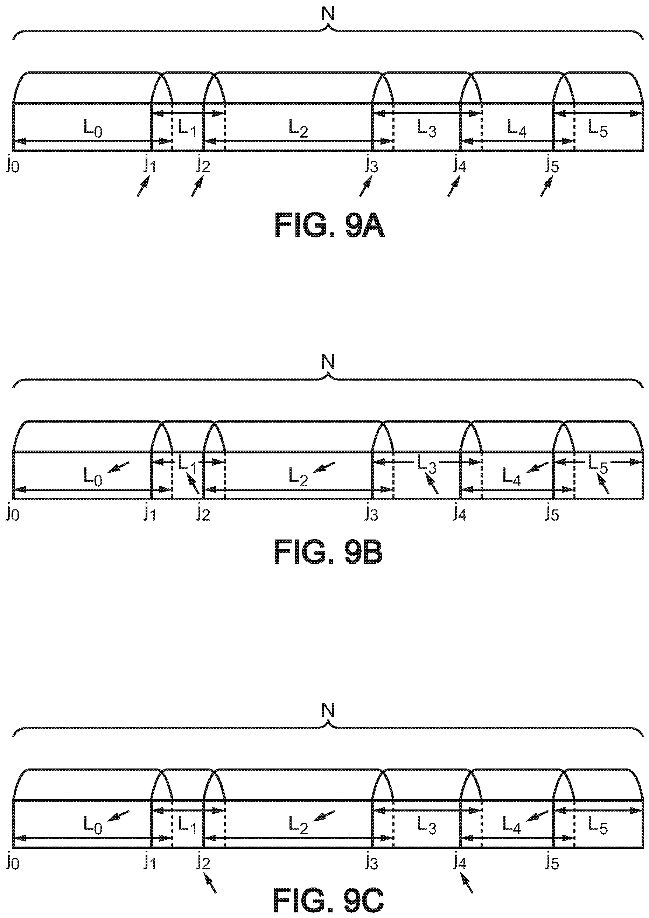

Dans un exemple de réalisation, en référence à la figure 9A représentant le signal de bruit injecté au signal de remplacement une fois que tous les blocs sont injectés, les instants de début d'écriture de blocs injectés sont déterminés de manière pseudo-aléatoire avec un taux de recouvrement constant. Sur les figures 9A à 11, les flèches indiquent les paramètres déterminés de manière pseudo-aléatoire. Les deux premiers paramètres (instant de début de bloc et taux de recouvrement) étant fixés, la durée temporelle de bloc est notamment déduite de ces deux premiers paramètres.

D'autres conditions peuvent également rentrer en ligne de compte. Par exemple, la somme des longueurs de chaque bloc peut être fixée telle qu'elle n'excède pas une durée N correspondante à la durée du signal à remplacer. Cette condition peut s'exprimer différemment en considérant que la somme de l'indice de début du dernier bloc avec la longueur de ce dernier bloc peut être fixée de telle sorte qu'elle soit inférieure à la durée N. En pratique, dans un procédé de génération de bruit par itération successives, ces conditions peuvent être vérifiées à chaque addition avec recouvrement.

Par exemple, pour 10 trames de données perdues à remplacer, on pondère le signal de bruit par 20 fenêtres de pondérations.

Comme précisé ci-avant, le terme pseudo-aléatoire est utilisé en mathématiques et en informatique pour désigner une suite de nombres qui s'approche d'un aléa statistiquement parfait. De par les procédés algorithmiques utilisés pour la générer et les sources employées, la suite ne peut être complètement considérée comme aléatoire. Bien sûr, les paramètres peuvent être générés de manière pseudo-aléatoire mais respecter certaines conditions, par exemple en respectant des conditions tenant à la longueur du signal à remplacer.

Dans une autre variante, en référence à la figure 9B, les durées temporelles des blocs ($L_0$ à $L_5$) sont déterminées de manière pseudo-aléatoire avec un taux de recouvrement constant. Les deux premiers paramètres étant fixés, l'indice de début d'écriture de bloc est notamment déduit de ces deux premiers paramètres. Dans cet exemple, aucun des paramètres du dernier bloc n'est déterminé de manière pseudo-aléatoire afin que la durée du signal résultant du recouvrement de tous les blocs ne soit pas supérieure à la durée N correspondante à la durée du signal à remplacer.

Dans une autre variante, en référence à la figure 9C, les durées temporelles des blocs et les valeurs des indices de début d'écriture de blocs injectés sont déterminées de manière pseudo-aléatoire pour un indice de fenêtre pair, avec un taux de recouvrement constant. Ainsi, $j_0$, $L_0$, $j_2$, $L_2$, $j_4$ et $L_4$ sont déterminés de manière pseudo-aléatoire et $j_1$, $L_1$, $j_3$, $L_3$, $j_5$ et $L_5$ sont déduits des paramètres déterminés de manière pseudo-aléatoire et du taux de recouvrement. Des conditions peuvent être fixées sur ces paramètres pour que durée du signal résultant du recouvrement de tous les s blocs n'excède pas la durée N correspondante à la durée du signal à remplacer.

Dans une autre variante, en référence à la figure 10, tous les paramètres sont déterminés de manière pseudo-aléatoire. Des conditions peuvent toutefois être fixées sur ces paramètres pour que la durée du signal résultant du recouvrement des blocs injectés n'excède pas la durée N correspondante à la durée du signal à remplacer. Dans cette configuration, notamment, la somme de deux fenêtres de pondérations successives n'est pas égale à 1 sur le segment de recouvrement entre ces deux fenêtres et la somme des carrés de deux fenêtres de pondérations successives n'est pas égale à 1 sur le segment de recouvrement entre ces deux fenêtres.

Ensuite, en revenant à l'étape S8 de la figure 2, on peut continuer optionnellement la construction du signal de remplacement en traitant la bande des hautes fréquences qui n'a pas été concernée par les étapes S3 à S7, simplement en répétant le signal dans cette bande de haute fréquences.

Dans une étape S9, le signal est synthétisé en ré-échantillonnant la bande des basses fréquences à sa fréquence Fc d'origine à l'étape S70, et en l'additionnant au signal issu de la répétition de l'étape S8 dans la bande des fréquences hautes.

A l'étape S10, on procède à un recouvrement-addition qui permet d'assurer une continuité entre le signal avant la perte de trame et le signal synthétisé et avec le signal synthétisé et le signal après la perte de trame.

Bien entendu, la présente invention ne se limite pas à la forme de réalisation décrite ci-avant ; elle s'étend à d'autres variantes.

Ainsi par exemple, la séparation en bandes de fréquences hautes et basses à l'étape S2 est optionnelle. Dans une variante de réalisation, le signal issu du buffer (étape S1) n'est pas séparé en deux sous-bandes et les étapes S3 à S10 restent identiques à celles décrites ci-avant. Néanmoins, le traitement des composantes spectrales dans les basses fréquences seulement permet avantageusement d'en limiter la complexité.

L'invention peut être mise en oeuvre dans un décodeur conversationnel, dans le cas d'une perte de trame. Matériellement, elle peut être mise en oeuvre dans un circuit pour le décodage, dans un terminal de téléphonie typiquement. A cet effet, un tel circuit CIR peut comporter ou être connecté à un processeur PROC, comme illustré sur la figure 3, et peut comporter une mémoire de travail MEM, programmée avec des instructions de programme informatique selon l'invention pour exécuter le procédé ci-avant. Par exemple, l'invention peut être mise en oeuvre dans un décodeur par transformée temps réel.

Plus particulièrement, on a décrit ci-avant un mode de réalisation basé sur une méthode de génération du bruit à partir d'un résidu entre un signal connu et un signal de synthèse. Bien entendu, il est possible aussi de calculer le résidu dans le domaine fréquentiel (en supprimant les composantes spectrales sélectionnées du spectre orignal) et d'obtenir un bruit de fond par transformée inverse.

On a décrit ci-avant un mode de réalisation basé sur une structure comportant des composantes spectrales déterminées à partir d'échantillons valides reçus au décodage et antérieurs à cette succession d'échantillons perdus. Bien entendu, ces composantes spectrales peuvent aussi être déterminées à partir d'échantillons reçus postérieurement à cette succession d'échantillons perdus. Ces composantes spectrales peuvent aussi être déterminées à partir d'échantillons reçus antérieurement et postérieurement à cette succession d'échantillons perdus. Ces composantes spectrales peuvent aussi être constantes.

## Revendications

**1.** Procédé de traitement d'un signal numérique, mis en oeuvre pendant un décodage dudit signal pour remplacer une succession d'échantillons perdue au décodage,
le procédé comportant les étapes :

- génération (S6) d'une structure d'un signal de remplacement de la succession perdue, ladite structure comportant des composantes spectrales déterminées à partir d'échantillons valides reçus au décodage (S1) et antérieurs à ladite succession d'échantillons perdue,
- génération d'un résidu (S603) entre un signal numérique (S602) disponible au décodeur comportant des échantillons valides reçus et un signal (S601) généré à partir desdites composantes spectrales,
- extraction (S605) de blocs dudit résidu,

procédé dans lequel on injecte lesdits blocs dans ladite structure par additions avec recouvrement (ADD) suivant des fenêtres de pondération de bloc (S608), lesdits blocs injectés se recouvrant au moins partiellement dans le temps, et dans lequel, lesdits blocs ayant un instant de début de bloc extrait ($i_k$) et une durée de bloc ($L_k$), au moins un paramètre parmi :

- ledit instant de début de bloc extrait,
- ladite durée de bloc,
- un instant de début d'écriture de bloc injecté ($j_k$), et
- un taux de recouvrement entre deux blocs injectés successifs,

est variable entre au moins deux blocs extraits ou injectés.

**2.** Procédé selon la revendication 1, dans lequel, lesdits blocs étant déterminés par un instant de début de bloc extrait ($i_k$) et une durée de bloc ($L_k$), au moins un paramètre parmi ledit instant de début de bloc extrait et ladite durée de bloc est déterminé de manière pseudo-aléatoire pour au moins un bloc extrait.

**3.** Procédé selon l'une des revendications précédentes, dans lequel ledit paramètre variable est variable de manière pseudo-aléatoire pour au moins un bloc injecté.

**4.** Procédé selon l'une des revendications précédentes, dans lequel la somme des fenêtres de pondération appliquées à deux blocs successifs injectés est égale à un sur le segment de recouvrement ($l_k$) entre ces deux blocs.

**5.** Procédé selon l'une des revendications 1 à 3, dans lequel la somme des carrés des fenêtres de pondération appliquées à deux blocs successifs injectés est égale à un sur le segment de recouvrement ($l_k$) entre ces deux blocs.

**6.** Procédé selon l'une des revendications précédentes, dans lequel on modifie le signe d'au moins un bloc injecté.

**7.** Procédé selon l'une des revendications précédentes, dans lequel on retourne temporellement au moins un bloc injecté.

**8.** Procédé selon l'une des revendications précédentes, dans lequel lesdits blocs sont d'abord injectés dans un signal de bruit intermédiaire, ledit signal de bruit intermédiaire étant lui-même injecté ultérieurement dans ladite structure.

**9.** Procédé selon l'une des revendications 1 à 7, dans lequel lesdits blocs sont injectés dans ladite structure en temps réel.

**10.** Programme informatique comportant des instructions pour la mise en oeuvre du procédé selon l'une des revendications 1 à 9, lorsque ces instructions sont exécutées par un processeur.

**11.** Dispositif de décodage d'un signal comportant une succession d'échantillons répartis en trames successives, le dispositif comportant des moyens (MEM, PROC) pour remplacer au moins une trame de signal perdue, comportant des moyens de :

- génération (S6) d'une structure d'un signal de remplacement de la succession perdue, ladite structure comportant des composantes spectrales déterminées à partir d'échantillons valides reçus au décodage (S1) et antérieurs à ladite succession d'échantillons perdue,
- génération d'un résidu (S603) entre un signal numérique (S602) disponible au décodeur comportant des échantillons valides reçus et un signal (S601) généré à partir desdites composantes spectrales,
- extraction (S605) de blocs dudit résidu,
- injection desdits blocs dans ladite structure,

dans lequel les moyens d'injection mettent en oeuvre des additions avec recouvrement suivant des fenêtres de pondération de blocs, lesdits blocs injectés se recouvrant au moins partiellement dans le temps,
et, dans lequel lesdits blocs ayant un instant de début de bloc extrait ($i_k$) et une durée de bloc ($L_k$), au moins un paramètre parmi :

- ledit instant de début de bloc extrait,
- ladite durée de bloc,
- un instant de début d'écriture de bloc injecté ($j_k$), et
- un taux de recouvrement entre deux blocs injectés successifs,

est variable entre au moins deux blocs extraits ou injectés.

## Patentansprüche

1. Verfahren zur Verarbeitung eines digitalen Signals, das während einer Decodierung des Signals eingesetzt wird, um eine bei der Decodierung ausgefallene Probenfolge zu ersetzen,
wobei das Verfahren die folgenden Schritte umfasst:

- Erzeugung (S6) einer Struktur eines Ersatzsignals der ausgefallenen Folge, wobei die Struktur Spektralkomponenten umfasst, die auf Basis von gültigen Proben, die bei der Decodierung (S1) empfangen werden und der ausgefallenen Probenfolge vorausgehen, bestimmt werden,
- Erzeugung eines Rests (S603) zwischen einem digitalen Signal (S602), das am Decoder verfügbar ist, umfassend gültige empfangene Proben, und einem Signal (S601), das auf Basis der Spektralkomponenten erzeugt wird,
- Extraktion (S605) von Blöcken des Rests, wobei bei dem Verfahren die Blöcke in die Struktur durch Ergänzungen mit Überdeckungen (ADD) gemäß Blockgewichtungsfenstern (S608) injiziert werden, wobei die injizierten Blöcke einander zumindest teilweise zeitlich überdecken,

und bei dem, wobei die Blöcke einen Anfangszeitpunkt eines extrahierten Blocks ($i_k$) und eine Blockdauer ($L_k$) haben, zumindest ein Parameter unter:

- dem Anfangszeitpunkt eines extrahierten Blocks,
- der Blockdauer,
- einem Anfangszeitpunkt eines Schreibens eines injizierten Blocks ($j_k$), und
- einer Überdeckungsrate zwischen zwei aufeinanderfolgenden injizierten Blöcken zwischen mindestens zwei extrahierten oder injizierten Blöcken variabel ist.

2. Verfahren nach Anspruch 1, bei dem, wobei die Blöcke durch einen Anfangszeitpunkt eines extrahierten Blocks ($i_k$) und eine Blockdauer ($L_k$) bestimmt werden, mindestens ein Parameter unter dem Anfangszeitpunkt eines extrahierten Blocks und der Blockdauer auf pseudo-zufällige Wiese für mindestens einen extrahierten Block bestimmt wird.

3. Verfahren nach einem der vorhergehenden Ansprüche, bei dem der variable Parameter für mindestens einen injizierten Block pseudo-zufällig variabel ist.

4. Verfahren nach einem der vorhergehenden Ansprüche, bei dem die Summe der Gewichtungsfenster, die an zwei aufeinanderfolgenden injizierten Blöcken angewandt werden, gleich eins auf dem Überdeckungssegment ($l_k$) zwischen diesen zwei Blöcken ist.

5. Verfahren nach einem der Ansprüche 1 bis 3, bei dem die Quadratsumme der Gewichtungsfenster, die an zwei aufeinanderfolgenden injizierten Blöcken angewandt werden, gleich eins auf dem Überdeckungssegment ($I_k$) zwischen diesen zwei Blöcken ist.

6. Verfahren nach einem der vorhergehenden Ansprüche, bei dem das Vorzeichen mindestens eines injizierten Blocks geändert wird.

7. Verfahren nach einem der vorhergehenden Ansprüche, bei dem mindestens ein injizierter Block zeitlich umgedreht wird.

8. Verfahren nach einem der vorhergehenden Ansprüche, bei dem die Blöcke zuerst in ein Zwischenrauschsignal injiziert werden, wobei das Zwischenrauschsignal selbst später in die Struktur injiziert wird.

9. Verfahren nach einem der Ansprüche 1 bis 7, bei dem die Blöcke in die Struktur in Echtzeit injiziert werden.

10. Informatikprogramm, umfassend Anweisungen für den Einsatz des Verfahrens nach einem der Ansprüche 1 bis 9, wenn diese Anweisungen von einem Prozessor ausgeführt werden.

11. Vorrichtung zur Decodierung eines Signals, umfassend eine Folge von Proben, die in aufeinanderfolgenden Rahmen verteilt sind, wobei die Vorrichtung Mittel (MEM, PROC) umfasst, um zumindest einen ausgefallenen Signalrahmen zu ersetzen, umfassend Mittel zur:

- Erzeugung (S6) einer Struktur eines Ersatzsignals der ausgefallenen Folge, wobei die Struktur Spektralkomponenten umfasst, die auf Basis von gültigen Proben, die bei der Decodierung (S1) empfangen werden und der ausgefallenen Probenfolge vorausgehen, bestimmt werden,
- Erzeugung eines Rests (S603) zwischen einem digitalen Signal (S602), das am Decoder verfügbar ist, umfassend gültige empfangene Proben, und einem Signal (S601), das auf Basis der Spektralkomponenten erzeugt wird,
- Extraktion (S605) von Blöcken des Rests,
- Injektion der Blöcke in die Struktur,

wobei die Injektionsmittel Ergänzungen mit Überdeckungen gemäß Blockgewichtungsfenstern einsetzen, wobei die injizierten Blöcke einander zumindest teilweise zeitlich überdecken,
und bei der, wobei die Blöcke einen Anfangszeitpunkt eines extrahierten Blocks ($i_k$) und eine Blockdauer ($L_k$) haben, zumindest ein Parameter unter:

- dem Anfangszeitpunkt eines extrahierten Blocks,
- der Blockdauer,
- einem Anfangszeitpunkt eines Schreibens eines injizierten Blocks ($j_k$), und
- einer Überdeckungsrate zwischen zwei aufeinanderfolgenden injizierten Blöcken zwischen mindestens zwei extrahierten oder injizierten Blöcken variabel ist.

## Claims

1. Method for processing a digital signal, implemented during a decoding of said signal to replace a succession of samples lost on decoding,
the method comprising the steps:

- generating (S6) a structure of a replacement signal in respect of the lost succession, said structure comprising spectral components determined on the basis of valid samples received on decoding (S1) and prior to said lost succession of samples,
- generating a residual (S603) between a digital signal (S602) available at the decoder comprising valid samples received and a signal (S601) generated on the basis of said spectral components,
- extracting (S605) blocks of said residual,

in which method said blocks are injected into said structure by additions with overlap (ADD) following block weighting windows (S608), said injected blocks overlapping at least partially in time,
and in which, said blocks having an instant of start of extracted block ($i_k$) and a block duration ($L_k$), at least one

parameter from among:

- said instant of start of extracted block,
- said block duration,
- an instant of start of writing of injected block ($j_k$), and
- a degree of overlap between two successive injected blocks,

is variable between at least two extracted or injected blocks.

2. Method according to Claim 1, in which, said blocks being determined by an instant of start of extracted block ($i_k$) and a block duration ($L_k$), at least one parameter from among said instant of start of extracted block and said block duration is determined in a pseudo-random manner for at least one extracted block.

3. Method according to one of the preceding claims, in which said variable parameter is variable in a pseudo-random manner for at least one injected block.

4. Method according to one of the preceding claims, in which the sum of the weighting windows applied to two injected successive blocks is equal to one on the overlap segment ($l_k$) between these two blocks.

5. Method according to one of Claims 1 to 3, in which the sum of the squares of the weighting windows applied to two injected successive blocks is equal to one on the overlap segment ($l_k$) between these two blocks.

6. Method according to one of the preceding claims, in which the sign of at least one injected block is modified.

7. Method according to one of the preceding claims, in which at least one injected block is temporally reversed.

8. Method according to one of the preceding claims, in which said blocks are firstly injected into an intermediate noise signal, said intermediate noise signal being itself injected subsequently into said structure.

9. Method according to one of Claims 1 to 7, in which said blocks are injected into said structure in real time.

10. Computing program comprising instructions for the implementation of the method according to one of Claims 1 to 9, when these instructions are executed by a processor.

11. Device for decoding a signal comprising a succession of samples distributed in successive frames, the device comprising means (MEM, PROC) for replacing at least one lost signal frame, comprising means for:

- generating (S6) a structure of a replacement signal in respect of the lost succession, said structure comprising spectral components determined on the basis of valid samples received on decoding (S1) and prior to said lost succession of samples,
- generating a residual (S603) between a digital signal (S602) available at the decoder comprising valid samples received and a signal (S601) generated on the basis of said spectral components,
- extracting (S605) blocks of said residual,
- injecting said blocks into said structure,

in which the injection means implement additions with overlap following block weighting windows, said injected blocks overlapping at least partially in time, and in which, said blocks having an instant of start of extracted block ($i_k$) and a block duration ($L_k$), at least one parameter from among:

- said instant of start of extracted block,
- said block duration,
- an instant of start of writing of injected block ($j_k$), and
- a degree of overlap between two successive injected blocks,

is variable between at least two extracted or injected blocks.

**FIG. 1A**

**FIG. 1B**

**FIG. 1C**

**FIG. 2**

FIG. 3

FIG. 4

**FIG. 5**

EP 2 987 165 B1

**FIG. 6**

**FIG. 7**

FIG. 8

**FIG. 9A**

**FIG. 9B**

**FIG. 9C**

FIG. 10

FIG. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MAHFUZ E.** *Packet loss concealment for voice transmission over IP networks*
- **EMRE GUNDUZHAN.** *A Linear Prédiction Based Packet Loss Concealment Algorithm for PCM Coded Speech*
- **ALEXEY LUKIN.** *Audio Engineering Society Convention Paper Parametric Interpolation of Gaps in Audio Signais*